# EUROPEAN PATENT APPLICATION

(11) **EP 4 512 925 A1**
(43) Date of publication of application: **26.02.2025**
(21) Application number: 24760307.9
(22) Date of filing: 19.02.2024
(51) Int. Cl.: C23C 16/448, C23C 16/455

(54) **FILM DEPOSITION METHOD USING ATOMIC LAYER DEPOSITION**

(30) Priority: 20.02.2023 JP 2023024296
(71) Applicant: DAIKIN INDUSTRIES, LTD., Osaka-shi, Osaka 530-0001 (JP); The University of Tokyo, Bunkyo-ku, Tokyo 113-8654 (JP)
(72) Inventor: YAMAUCHI, Akiyoshi, Osaka-Shi, Osaka 530-0001 (JP); MATSUNAGA, Takayuki, Osaka-Shi, Osaka 530-0001 (JP); KISHIKAWA, Yosuke, Osaka-Shi, Osaka 530-0001 (JP); HORIGUCHI, Kazunori, Osaka-Shi, Osaka 530-0001 (JP); NAKAMURA, Shingo, Osaka-Shi, Osaka 530-0001 (JP); SAGISAKA, Shigehito, Osaka-Shi, Osaka 530-0001 (JP); SHIMOGAKI, Yukihiro, Tokyo 113-8654 (JP); MOMOSE, Takeshi, Tokyo 113-8654 (JP); DEURA, Momoko, Tokyo 113-8654 (JP); SATO, Noboru, Tokyo 113-8654 (JP); YAMAGUCHI, Jun, Tokyo 113-8654 (JP)
(74) Representative: Hoffmann Eitle
(86) International application number: PCT/JP2024/005773
(87) International publication number: WO 2024/177008

(57) **Abstract**

The present disclosure provides a method for producing a thin film by atomic layer deposition, the method comprising:
vaporizing a raw material liquid comprising a raw material compound in a vaporizer;
introducing the raw material compound vaporized into a film deposition chamber; and
forming a thin film on a substrate, wherein
the method comprises discharging a gas phase in the vaporizer.

## Description

### Technical Field

The present disclosure relates to a film deposition method by atomic layer deposition.

### Background Art

Atomic layer Deposition (hereinafter, also referred to as "ALD") is known as a method for depositing a film on various substrates. In the film deposition processes using the ALD, metal complexes are generally used as raw materials.

### Citation List

### Patent Literature

Patent Literature 1: JP 2021-36068 A

### Summary of Invention

### Technical Problem

In the ALD, organometallic compounds are used as raw materials, but the organometallic compounds have low volatility and have a low vapor pressure, which can cause a problem. To increase the vapor pressure of an organometallic compound, increasing the heating temperature during volatilizing the organometallic compound is conceivable. However, when the heating temperature is increased, the vapor pressure of the organometallic compound is increased, but the decomposition of the organometallic compound occurs even though it is only in a slight amount. A produced decomposition product mixes as impurities into the raw material compound, and therefore the vapor pressure of the raw material compound in a vaporizer can be unstable. In addition, there is a risk of allowing the decomposition product to mix into the film.

An object of the present disclosure is to provide the atomic layer deposition that enables stable film deposition.

### Solution to Problem

The present disclosure includes the following embodiments.
[1] A method for producing a thin film by atomic layer deposition, the method including:
   vaporizing a raw material liquid containing a raw material compound in a vaporizer;
   introducing the raw material compound thus vaporized into a film deposition chamber; and
   forming a thin film on a substrate, wherein
   the method includes discharging a gas phase part in the vaporizer.
[2] The method for producing a thin film according to [1], including motioning the raw material liquid in the vaporizer to increase a contact area between the raw material liquid and the gas phase.
[3] The method for producing a thin film according to [2], wherein the motion of the raw material liquid is caused by stirring the raw material liquid with a stirring member.
[4] The method for producing a thin film according to [2] or [3], wherein the contact area between the raw material liquid and the gas phase is 1.1 times or more the contact area without the motion of the raw material liquid.
[5] The method for producing a thin film according to any one of [1] to [4], wherein a temperature of the raw material liquid in the vaporizer is 400°C or lower.
[6] The method for producing a thin film according to any one of [1] to [5], wherein a partial pressure of the raw material compound in a section connecting the vaporizer and the film deposition chamber is substantially the same as a partial pressure of the raw material compound in the vaporizer.
[7] The method for producing a thin film according to any one of [1] to [6], wherein the raw material compound is a metal carbonyl complex, a metal metallocene complex, or a metal amidinate complex.
[8] The method for producing a thin film according to [7], wherein the metal is Co or W.
[9] The method for producing a thin film according to any one of [1] to [8], wherein the raw material compound is represented by 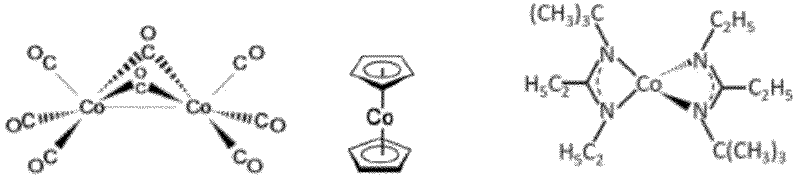 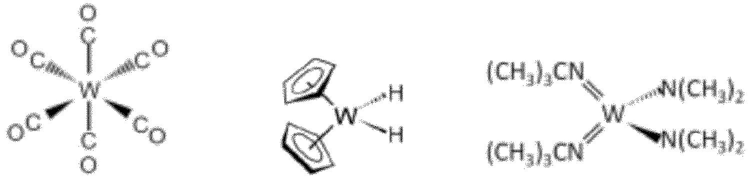
[10] The method for producing a thin film according to any one of [1] to [9], wherein the gas phase part contains a decomposition product of the raw material compound.
[11] The method for producing a thin film according to any one of [1] to [10], wherein the substrate is a copper substrate.
[12] The method for producing a thin film according to any one of [1] to [11], including:
   Step A: vaporizing the raw material liquid containing the raw material compound in the vaporizer;
   Step B: introducing the raw material compound vaporized in the vaporizer into the film deposition chamber;
   Step C: introducing a reactive gas into the film deposition chamber; and
   Step D: discharging the gas phase part in the vaporizer,
   wherein a cycle comprises
      while Step A, carrying out Step B, and subsequently Step C,
      carrying out Step D between Step B and the next Step B.
[13] The method for producing a thin film according to any one of [1] to [12], including:
   (i) introducing the raw material compound into the film deposition chamber, thereby depositing the raw material compound on the substrate to form a film of the raw material compound;
   (ii) exhausting the raw material compound left in the film deposition chamber;
   (iii) introducing a reactive gas into the film deposition chamber, thereby reacting the raw material compound deposited on the substrate with the reactive gas to reduce the raw material compound and form a film; and
   (iv) exhausting the reactive gas left unreacted and a by-product gas in the film deposition chamber.
[14] The method for producing a thin film according to any one of [1] to [13], including:
   Step A: vaporizing the raw material liquid containing the raw material compound in the vaporizer;
   Step B: introducing the raw material compound vaporized in the vaporizer into the film deposition chamber;
   Step C: introducing a reactive gas into the film deposition chamber; and
   Step D: discharging the gas phase part in the vaporizer, and
   wherein a cycle comprises
      while Step A, carrying out Step B, and subsequently Step C, and
      carrying out Step D between Step B and the next B,
   the raw material compound is represented by 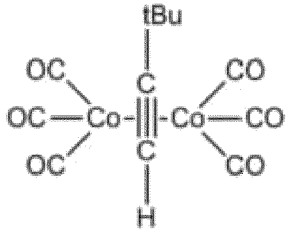
   the method includes a motion of the raw material liquid in the vaporizer by stirring the raw material liquid with a stirring member, thereby motioning the raw material liquid to increase a contact area between the raw material liquid and the gas phase,
   a temperature of the raw material liquid in the vaporizer is 350°C or lower,
   the gas phase part contains a decomposition product of the raw material compound, and
   the substrate is a copper substrate.
[15] A film deposition apparatus including:
   a vaporizer that vaporizes a raw material liquid containing a raw material compound;
   a discharging member that discharges a gas phase in the vaporizer; and
   a film deposition chamber that deposits a film on a substrate by atomic layer deposition.
[16] The film deposition apparatus according to [15], wherein the vaporizer includes a motion member that moves the raw material liquid containing the raw material compound.
[17] The film deposition apparatus according to [15] or [16], wherein the motion member is a stirring member.
[18] The film deposition apparatus according to any one of [15] to [17], wherein a temperature of the raw material liquid in the vaporizer is 400°C or lower.
[19] The film deposition apparatus according to any one of [15] to [18], further including a connecting section that connects the vaporizer and the film deposition chamber, wherein a partial pressure of the raw material compound in the vaporizer is substantially the same as a partial pressure of the raw material compound in the vaporizer.

### Advantageous Effect of Invention

According to the method of the present disclosure, ALD stably forms a film.

### Brief Description of Drawings

[Figure 1] Figure 1 is a schematic diagram showing an example of a film deposition apparatus of the present disclosure.
[Figure 2] Figure 2 is a graph showing a vaporization rate of a raw material compound in Example.
[Figure 3] Figure 3 is a graph showing a vaporization rate of a raw material compound in Comparative Example.

### Description of Embodiments

Hereinafter, the present disclosure will be described. Note that the film deposition method and film deposition apparatus which will be described below are for embodying the technical idea of the invention according to the present disclosure and the invention according to the present disclosure is not limited to the following unless particular description is made.

A method for producing a thin film of the present disclosure includes:
vaporizing a raw material liquid comprising a raw material compound in a vaporizer; and
introducing the raw material compound thus vaporized into a film deposition chamber to deposit a film on a substrate, wherein
the method further includes discharging a gas phase part in the vaporizer.

The method for producing a thin film of the present disclosure can be carried out by using the apparatus for producing a film of the present disclosure. The apparatus for producing a film of the present disclosure includes:
a vaporizer that vaporizes a raw material liquid comprising a raw material compound;
a discharging member that discharges a gas phase part in the vaporizer; and
a film deposition chamber that deposits a film on a substrate, wherein
the vaporizer includes a motion member that motions the raw material liquid containing the raw material compound.

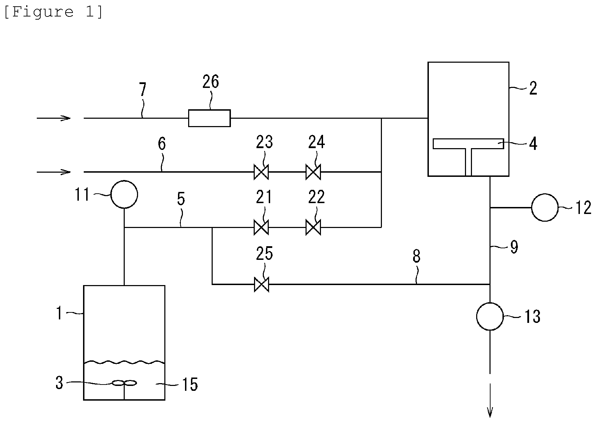

Figure 1 shows an embodiment of the film deposition apparatus of the present disclosure. The film deposition apparatus of the present disclosure includes a vaporizer 1 and a film deposition chamber 2, and the vaporizer 1 includes a stirrer (motion member) 3. The film deposition chamber 2 includes a film deposition table 4. The vaporizer 1 and the film deposition chamber 2 are connected with a main line (connection section) 5. A line 9 for discharging the gas after film deposition is connected to the film deposition chamber 2. A line 6 for supplying a reactive gas and a line 7 for supplying a carrier gas are connected to the main line 5. Further, the main line 5 and the line 9 are connected with a line (discharging member) 8. The line 8 serves as a bypass for the main line 5 and the line 9, and enables discharging the gas in the gas phase in the vaporizer 1 outside the film deposition apparatus without passing the gas through the film deposition chamber 2. A raw material liquid 15 containing a raw material compound is present in the vaporizer 1, and the raw material compound vaporized in the vaporizer passes through the main line 5 and is mixed with the reactive gas supplied from the line 6 and a carrier gas supplied from a line 7 and transferred to the film deposition chamber 2. Each gas is exhausted from the film deposition chamber 2 through the line 9 after the reaction. On the other hand, the gas phase part in the vaporizer 1 can be discharged from the line 9 through the line 8 without passing through the film deposition chamber 2. The main line 5 is provided with a pump 11 near the vaporizer 1. The line 9 is provided with a pump 12 near the film deposition chamber 2 and is provided a pump 13 at a position downstream from the part where the line 9 and the line 8 are connected. The main line 5 is provided with valves 21, 22 for adjusting a gas flow rate. The line 6 is provided with valves 23, 24 for adjusting a gas flow rate. The line 8 is provided with a valve 25 for adjusting a gas flow rate. The line 7 is provided with a mass flow controller (hereinafter, also referred to as "MFC") 26 for adjusting a gas flow rate.

### (Step A)

The method for producing a film of the present disclosure includes vaporizing the raw material liquid containing the raw material compound in the vaporizer (hereinafter, also referred to as "Step A").

The raw material compound is an organometallic compound.

Examples of the metal atom in the organometallic compound include transition metals, such as cobalt, nickel, copper, vanadium, niobium, tantalum, chromium, molybdenum, and tungsten.

In a preferred embodiment, the metal atom is cobalt or tungsten. For example, when a film is deposited on copper wiring, the disconnection of the copper wiring can be prevented by using cobalt or tungsten as the metal atom.

Examples of the organic ligand in the organometallic compound include alkyl, alkenyl, cycloalkyl, aryl, alkynyl, alkylimino, amino, dialkylaminoalkyl, monoalkylamino, dialkylamino, diamine, di(silyl-alkyl)amino, di(alkyl-silyl)amino, disilylamino, alkoxy, alkoxyalkyl, hydrazide, phosphide, nitril, dialkylaminoalkoxy, alkoxyalkyldialkylamino, siloxy, diketonato, cyclopentadienyl, silyl, pyrazolate, guanidinate, phosphoguanidinate, amidinato, phosphoamidinato, ketoiminato, diketiminato, and carbonyl.

In a preferred embodiment, the organic ligand is carbonyl, cyclopentadienyl, or amidinato.

In a preferred embodiment, the organometallic compound is at least one of the following compounds.

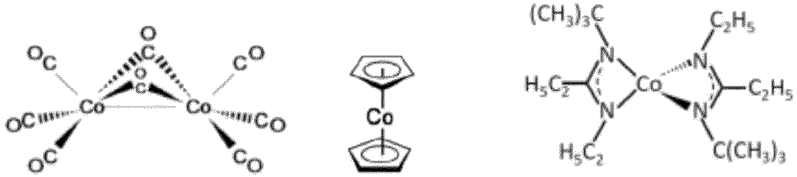

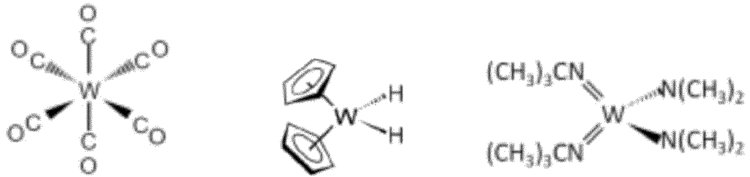

In some embodiments, only one of the above raw material compounds is used, or two or more of the above raw material compounds are used in combination.

The raw material compound is vaporized in the vaporizer 1.

The raw material liquid may contain impurities.

Examples of the impurities include: a decomposition product produced by the decomposition of the raw material compound; and water.

In a preferred embodiment, the raw material liquid substantially consists of the raw material compound.

In Figure 1, there is only one vaporizer 1, but in some embodiments where, for example, two or more raw material compounds are used, two or more vaporizers 1 are used.

The vaporizer 1 includes a motion member 3. The motion member 3 is a member that motions the raw material liquid present in the vaporizer 1. Due to the motion, the contact area between the raw material liquid and the gas phase in the vaporizer 1 is increased.

The raw material liquid is motioned in the vaporizer to increase the contact area between the raw material liquid and the gas phase, thus providing a higher vaporization rate of the raw material liquid and a higher partial pressure of the raw material compound in the gas phase in the vaporizer. In other words, motioning the raw material liquid in the vaporizer to increase the contact area between the raw material liquid and the gas phase enables the vapor pressure of the raw material compound in the gas phase in the vaporizer to reach saturated vapor pressure earlier. When the time required for reaching the saturated vapor pressure is shortened, thereby the film deposition by the ALD is stabilized. In addition, the time between film deposition cycles can be shortened, so that the film deposition rate can be improved.

The motion member 3 is not limited as long as it can move the raw material liquid. Examples of the motion member include a stirring member and a vibration member.

Examples of the stirring member include stirring members adopting a system in which a stirring member in a liquid is rotated, a system in which the container itself is rotated, and a system in which the raw material compound is jetted into a liquid.

In a preferred embodiment, the stirring member is a member adopting a system in which a stirring member is placed in a liquid and rotated. Examples of the stirring member include blenders of a puddle type, a tumbler type, and a ribbon type.

Examples of the vibration member include vibration members adopting a system in which ultrasonic waves are applied to a liquid to vibrate the liquid, and a system in which the container itself is vibrated.

The contact area between the raw material liquid and the gas phase in the vaporizer can be preferably 1.1 times or more, more preferably 1.5 times or more, still more preferably 2.0 times or more, and further preferably 3.0 times or more the contact area of the raw material liquid without the motion. The increase in the contact area can enhance the vaporization rate of the raw material liquid. The contact area can be preferably 100 times or less, and more preferably 50 times or less the contact area of the raw material liquid without the motion.

The contact area between the raw material liquid and the gas phase can be calculated by simulation using fluid analysis software.

In the film deposition method of the present disclosure, the vaporization rate of the raw material liquid is high, and therefore the temperature in the vaporizer and the temperature of the raw material liquid can be set to relatively low temperatures. The temperature of the raw material liquid in the vaporizer 1 is preferably 400°C or lower, and more preferably 350°C or lower. The relatively low temperature can suppress undesirable decomposition of the raw material compound, and prevent contamination of a deposited film by impurities. In addition, the relatively low temperature provides an excellent energy efficiency. The temperature of the raw material liquid can be, for example, 150°C or higher, and preferably 200°C or higher.

In some embodiments, the raw material compound is heated by heating the vaporizer with a heater or the like from outside, or is heated with a heater or the like provided inside of the vaporizer. As for other methods, in some embodiments, the raw material compound is heated by injecting a heated medium, such as, for example, a carrier gas, into the raw material liquid, or in some embodiments, the raw material liquid heated outside is introduced into the vaporizer.

The pressure inside the vaporizer 1 can be 100 Pa to 1.5 kPa.

### (Step B)

The film deposition method of the present disclosure includes introducing the raw material compound vaporized in Step A into a film deposition chamber (hereinafter, also referred to as "Step B").

The raw material compound introduced into the film deposition chamber is deposited on the substrate disposed in the film deposition chamber to form a film of the raw material compound.

The gas of the raw material compound generated in the vaporizer 1 is transferred into the film deposition chamber 2 through the main line 5. The gas of the raw material compound left in the film deposition chamber 2 is discharged outside the system from the line 9.

In some embodiments, the main line 5 has a valve for adjusting the pressure inside the vaporizer 1 or adjusting the flow rate of the raw material compound to the film deposition chamber 2. In the embodiment shown in Figure 1, the main line 5 has valves 21, 22.

In some embodiments, a line for transferring the carrier gas, a line for transferring the reactive gas, and the like are connected to the main line 5. In the embodiment shown in Figure 1, the line 6 for transferring the reactive gas and the line 7 for transferring the carrier gas are connected to the main line 5.

In some embodiments, the line 7 has a member for controlling the flow rate of the carrier gas. In some embodiments, the line 7 has a mass flow controller for controlling the flow rate of the carrier gas. In the embodiment shown in Figure 1, the line 7 has a mass flow controller 26. In the embodiment shown in Figure 1, the gas of the raw material compound and the carrier gas are mixed in the main line 5. Note that in Figure 1, the line 7 is connected to the main line 5, but in some embodiments, the line 7 is connected to the vaporizer 1 to mix the raw material compound and the carrier gas in the vaporizer.

Examples of the carrier gas include inert gases, such as nitrogen and noble gases, and nitrogen or an argon gas is preferably used.

The main line 5 can have a heating member. Examples of the heating member include a heater to be disposed around a pipe, typically a jacket heater.

As for the heating, the temperature is preferably set to a temperature that provides the partial pressure of the raw material compound in the vaporizer 1 that is substantially the same as the partial pressure of the raw material compound in the section that connects the vaporizer 1 and the film deposition chamber 2 (that is, the main line 5). The partial pressure of the raw material compound in the vaporizer 1 that is substantially the same as the partial pressure of the raw material compound in the line 5 makes it easy to control the film deposition and improves the quality of a resultant film.

The partial pressure of the raw material compound in the vaporizer 1 that is substantially the same as the partial pressure of the raw material compound in the section that connects the vaporizer 1 and the film deposition chamber 2 (that is, the main line 5) means that the difference between the partial pressures is within 50 Pa. The difference between the partial pressure of the raw material compound in the vaporizer 1 and the partial pressure of the raw material compound in the section that connects the vaporizer 1 and the film deposition chamber 2 (that is, the line 5) is preferably within 30 Pa, more preferably within 10 Pa, and still more preferably within 5 Pa.

### (Step C)

The film deposition method of the present disclosure can include introducing the reactive gas into the film deposition chamber (hereinafter, also referred to as "Step C").

The reactive gas introduced into the film deposition chamber reacts with the raw material compound deposited on the substrate to reduce the raw material compound. Thereby, a metal film is formed on the substrate.

The reactive gas is introduced into the film deposition chamber 2 from the line 6 through the main line 5. The reactive gas is discharged outside the system from the line 9 after the reaction in the film deposition chamber 2.

In some embodiments, the line 6 has a member for controlling the flow rate of the reactive gas. In the embodiment shown in Figure 1, the line 6 has valves 23, 24 for controlling the flow rate of the reactive gas. In the embodiment shown in Figure 1, the reactive gas is mixed with the carrier gas in the main line 5. Note that in Figure 1, the line 7 is connected to the main line 5, but in some embodiments, the line 7 is connected to the film deposition chamber 2 to introduce the reactive gas directly into the film deposition chamber 2.

### (Step D)

The film deposition method of the present disclosure can include removing the gas phase part in the vaporizer (hereinafter, also referred to as "Step D").

While the gas of the raw material liquid generated in the vaporizer 1 is not discharged outside the vaporizer 1, the concentration of impurities such as a decomposition product of the raw material compound, particularly the concentration of a low-boiling-point component, increases in the vaporizer 1, and as a result, the concentration of the decomposition product and the like of the raw material compound in the raw material liquid can increase. In this state, the vapor pressure of the raw material compound is unstable, which makes stable film deposition difficult. In addition, the impurities are highly likely to mix into the film. The concentration of the impurities in the vaporizer 1 is lowered by removing the gas phase part in the vaporizer in Step D, which makes the vapor pressure of the raw material compound stable, enabling stable film deposition. In addition, mixing of impurities into the film can be suppressed.

In the embodiment shown in Figure 1, the gas phase part in the vaporizer 1 contains the impurities. The gas phase part containing the impurities is discharged outside the system through the line 8 connected to the main line 5.

The line 8 serves as a bypass between the line 5 and the line 9. This enables discharging the gas in the gas phase in the vaporizer 1 outside the film deposition apparatus without passing the gas through the film deposition chamber 2. The line 8 has a valve 25 for turning on or off the discharge of the gas.

Step D is carried out before Step B. Specifically, Step D is carried out within 1 minute, preferably within 30 seconds, more preferably within 20 seconds, and still more preferably within 10 seconds before Step B.

In some embodiments, Step D and Step C are carried out simultaneously or separately. When Step D and Step C are carried out simultaneously, only a part of Step D or Step C is carried out simultaneously with Step C or Step D respectively in some embodiments.

In a preferred embodiment, the method for producing a thin film of the present disclosure includes carrying out a cycle including while Step A, carrying out Step B, and subsequently Step C, and further carrying out Step D between Step B and the next Step B. In some embodiments, Step D is carried out in parallel with C.

Next, the reaction in the film deposition chamber 2 will be described. Firstly, (i) the raw material compound is introduced into the film deposition chamber 2 as described above, and thereby the raw material compound is deposited on the substrate and a film of the raw material compound is formed. Subsequently, (ii) the raw material compound left in the film deposition chamber 2 is exhausted. Subsequently, (iii) the reactive gas is introduced into the film deposition chamber 2, thereby the raw material compound deposited on the substrate and the reactive gas react to reduce the raw material compound and form a film, typically a metal film. Subsequently, (iv) the reactive gas left unreacted and a by-product gas are exhausted. A desired monoatomic film is obtained by (i) to (iv). In addition, when (i) to (iv) are repeated, thereby a film having a desired thickness is formed.

### (Step (i))

In Step (i), the raw material compound is introduced, the raw material compound is deposited on the substrate, and a film of the raw material compound is formed.

The substrate is usually set on a film deposition table provided in the film deposition chamber 2 before the raw material compound is introduced.

Examples of the material that forms the substrate include, but not limited to, metals, such as copper, silver, gold, platinum, nickel, palladium, and aluminum; silicon; ceramics, such as indium arsenide, indium gallium arsenide, silicon oxide, silicon nitride, silicon carbide, titanium nitride, tantalum oxide, tantalum nitride, titanium oxide, titanium nitride, ruthenium oxide, zirconium oxide, hafnium oxide, lanthanum oxide, and gallium nitride; and glass.

In an embodiment, the material that forms the substrate is copper, silver, gold, platinum, nickel, palladium, or aluminum, and is preferably copper.

The shape of the substrate is not limited and is, in some embodiments, a plate-like, rod-like, spherical, layered, fibrous, scale-like shape, or the like.

In an embodiment, the shape of the substrate can be a layered shape provided on the substrate, for example, wiring on a circuit board.

The temperature of the substrate in depositing the raw material compound on the substrate can be for example 20 to 600°C, preferably 50 to 500°C, more preferably 100 to 450°C, and still more preferably 100 to 400°C.

### (Step (ii))

In Step (ii), the raw material compound left in the film deposition chamber 2 is exhausted.

Examples of the exhaustion method include a method of purging the inside of the system with an inert gas such as nitrogen or argon, a method of reducing the pressure inside the system for exhaustion, and a method in which these are combined.

### (Step (iii))

In Step (iii), the reactive gas is introduced into the film deposition chamber 2, and the raw material compound deposited on the substrate and the reactive gas react to reduce the raw material compound, and thereby a metal film is formed.

The reactive gas is not limited as long as it can react with the raw material compound, and examples of the reactive gas include hydrogen, oxygen, formic acid, hydrogen chloride, hydrogen bromide, hydrogen iodide, monochlorosilane, dichlorosilane, trichlorosilane, tetrachlorosilane, boron trichloride, boron tribromide, methyl iodide, and methyl bromide.

The temperature of the substrate in introducing the reactive gas into the film deposition chamber 2 can be for example 20 to 600°C, preferably 50 to 500°C, more preferably 100 to 450°C, and still more preferably 100 to 400°C.

### (Step (iv))

In Step (iv), the reactive gas left unreacted and a by-product gas are exhausted.

Examples of the exhaustion method include a method of purging the inside of the system with an inert gas such as nitrogen or argon, a method of reducing the pressure inside the system for exhaustion, and a method in which these are combined.

The gasses exhausted in Step (ii) and Step (iv) are exhausted through the line 9. In some embodiments, the line 9 has an exhaustion valve for adjusting the flow rate of exhaustion or adjusting the pressure in the film deposition chamber 2.

As described above, a cycle contains Step (i) to Step (iv) and the cycle can be repeated a plurality of times according to a desired film thickness.

One of the embodiments of the present disclosure is described above, but the present disclosure is not limited to the embodiment, and various modifications of the present disclosure are possible.

### Examples

Hereinafter, the present disclosure will be described in an example, but the present disclosure is not limited to the following example.

A thin film was produced as described below using an apparatus as shown in Figure 1 by atomic layer deposition.

The process conditions are as described below.

Raw material compound: (3,3-dimethyl-1-butyne) dicobalthexacarbonyl: 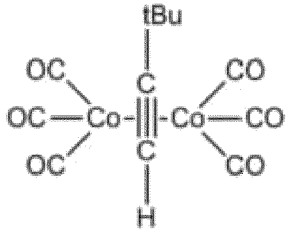
Flow rate of raw material compound gas: 0.003 scc (Standard Cubic Sentimeters)/cycle × 5 cycles
Reactive gas: hydrogen Flow rate of reactive gas: 14 scc/cycle × 3 cycles
Carrier gas: nitrogen
Flow rate of carrier gas: 5 ccpm
Temperature setting of vaporizer: 70°C
Temperature setting of film deposition chamber: 200°C

### <Common Process>

The raw material compound as a raw material liquid is heated at the set temperature under stirring. Simultaneously, the film deposition chamber is heated to the setting temperature. The carrier gas is supplied at the set flow rate (5 sccm) with a mass flow controller. The valve 25 is opened for 10 seconds to remove the gas phase in the vaporizer. Thereafter, the valve 25 is closed.

### <Example Processes>

The following processes are performed after the above-described common process.
(1) The following is repeated five times.
   The valve 21 is opened. → The valve 21 is closed after one second. → The valve 22 is opened after 0.75 seconds. → The valve 22 is closed after one second.
(2) The valve 25 is opened 0.25 seconds after (1), and the valve 25 is closed after two seconds.
(3) The following is repeated three times two seconds after (1).
   The valve 23 is opened. → The valve 23 is closed after one second. → The valve 24 is opened after 0.75 seconds. → The valve 24 is closed after one second.
(4) (1) is performed again five seconds after (3).

### <Comparative Example Processes>

(1) The following is repeated five times.
   The valve 21 is opened. → The valve 21 is closed after one second. → The valve 22 is opened after 0.75 seconds. → The valve 22 is closed after one second.
(2) The following is repeated three times two seconds after (1).
   The valve 23 is opened. → The valve 23 is closed after one second. → The valve 24 is opened after 0.75 seconds. → The valve 24 is closed after one second.
(3) (1) is performed again five seconds after (2).

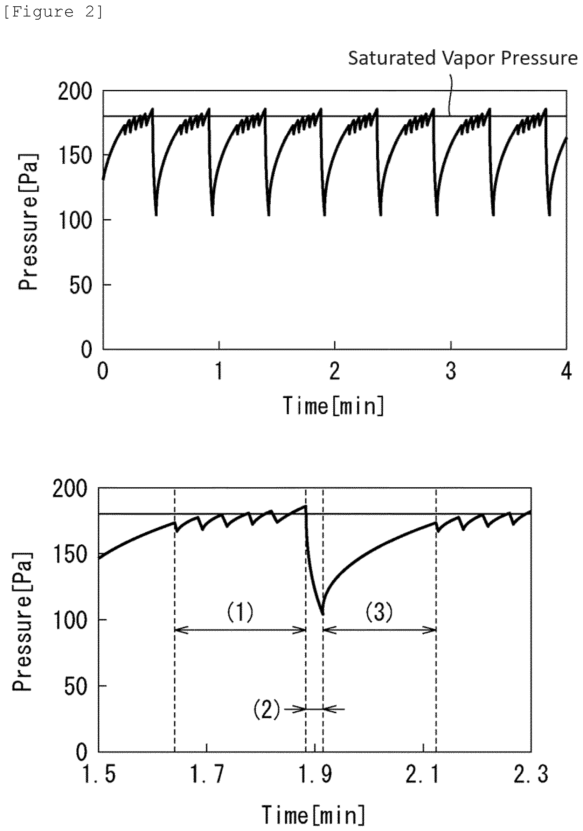

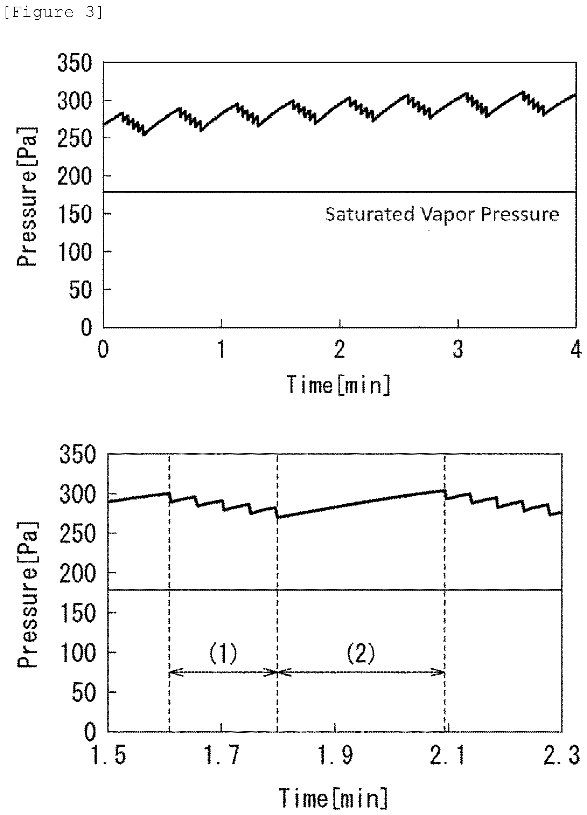

Changes in pressure in the vaporizer in the above-described processes were measured. Figure 2 shows the result of the example, and Figure 3 shows the result of the comparative example.

The little-by-little fluctuations near the saturated vapor pressure in Figure 2 are fluctuations in pressure during the pulse supply in the example process (1). Vacuum evacuation was performed to about 100 Pa by the example process (2) after the pulse supply was completed, thereby impurities due to pyrolysis were removed. Thereafter, a stirring member for the raw material was provided, and thereby vaporization of the raw material progressed rapidly, so that the vapor pressure of the raw material was recovered near the saturated vapor pressure after the reactive gas was supplied in the example process (3), and when the raw material was supplied again in a pulse in the example process (4), the raw material was able to be supplied at a constant pressure. This demonstrates that a stable ALD process can be performed.

On the other hand, in the comparative example processes, the vaporization of the raw material progressed rapidly due to the stirring member, but removal of impurities by vacuum evacuation was absent, and therefore a decomposed product was accumulated in the container. As shown in Figure 3, the pressure in the container significantly exceeded the saturated vaper pressure, so that the pressure during the pulse supply of the raw material (little-by-little fluctuation part) continued to increase as the number of cycles increased. This means that the raw material cannot be supplied at a constant pressure and, on top of that, the ratio of the impurities in the raw material also continues to increase, which demonstrates that a stable ALD process cannot be performed.

### Industrial Applicability

According to the film deposition method of the present disclosure, a high-purity thin film can be efficiently deposited, and therefore the film deposition method of the present disclosure can be used for various applications, such as, for example, production of a circuit board.

### Reference Signs List

- 1: Vaporizer
- 2: Film deposition chamber
- 3: Stirrer
- 4: Film deposition table
- 5: Main line (pipe)
- 6: Line
- 7: Line
- 8: Line
- 9: Line
- 11: Pump
- 12: Pump
- 13: Pump
- 15: Raw material liquid
- 21, 22: Valve
- 23, 24: Valve
- 25: Valve
- 26: Mass flow controller

## Claims

1. A method for producing a thin film by atomic layer deposition, the method comprising:
vaporizing a raw material liquid comprising a raw material compound in a vaporizer;
introducing the raw material compound vaporized into a film deposition chamber; and
forming a thin film on a substrate, wherein
the method comprises discharging a gas phase part in the vaporizer.

2. The method for producing a thin film according to claim 1, comprising motioning the raw material liquid in the vaporizer to increase a contact area between the raw material liquid and the gas phase.

3. The method for producing a thin film according to claim 2, wherein the motion of the raw material liquid is caused by stirring the raw material liquid with a stirring member.

4. The method for producing a thin film according to claim 2, wherein the contact area between the raw material liquid and the gas phase is 1.1 times or more the contact area of the raw material liquid without the motion.

5. The method for producing a thin film according to claim 1, wherein a temperature of the raw material liquid in the vaporizer is 400°C or lower.

6. The method for producing a thin film according to claim 1, wherein a partial pressure of the raw material compound in a section connecting the vaporizer and the film deposition chamber is substantially the same as a partial pressure of the raw material compound in the vaporizer.

7. The method for producing a thin film according to claim 1, wherein the raw material compound is a metal carbonyl complex, a metal metallocene complex, or a metal amidinate complex.

8. The method for producing a thin film according to claim 7, wherein the metal is Co or W.

9. The method for producing a thin film according to claim 1, wherein the raw material compound is represented by

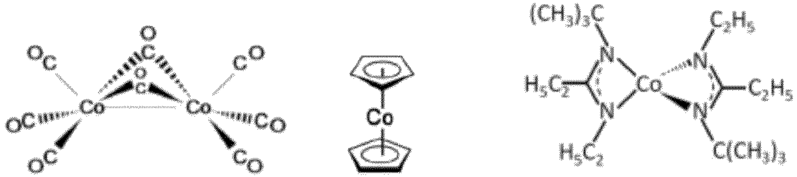

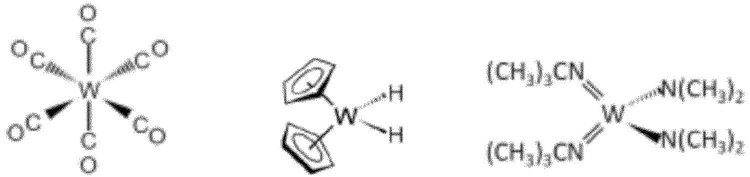

10. The method for producing a thin film according to claim 1, wherein the gas phase part comprises a decomposition product of the raw material compound.

11. The method for producing a thin film according to claim 1, wherein the substrate is a copper substrate.

12. The method for producing a thin film according to claim 1, comprising:
Step A: vaporizing the raw material liquid comprising the raw material compound in the vaporizer;
Step B: introducing the raw material compound vaporized in the vaporizer into the film deposition chamber;
Step C: introducing a reactive gas into the film deposition chamber; and
Step D: discharging the gas phase part in the vaporizer,
wherein a cycle comprises
while Step A, carrying out Step B, and subsequently Step C,
carrying out Step D between Step B and the next Step B.

13. The method for producing a thin film according to claim 1, comprising:
(i) introducing the raw material compound into the film deposition chamber, thereby depositing the raw material compound on the substrate to form a film of the raw material compound;
(ii) exhausting the raw material compound left in the film deposition chamber;
(iii) introducing a reactive gas into the film deposition chamber, thereby reacting the raw material compound deposited on the substrate with the reactive gas to reduce the raw material compound and form a film; and
(iv) exhausting the reactive gas left unreacted and a by-product gas in the film deposition chamber.

14. The method for producing a thin film according to claim 1, comprising:
Step A: vaporizing the raw material liquid comprising the raw material compound in the vaporizer;
Step B: introducing the raw material compound vaporized in the vaporizer into the film deposition chamber;
Step C: introducing a reactive gas into the film deposition chamber; and
Step D: discharging the gas phase part in the vaporizer, and
wherein a cycle comprises
while Step A, carrying out Step B, and subsequently Step C, and
carrying out Step D between Step B and the next Step B,
the raw material compound is the following compound, 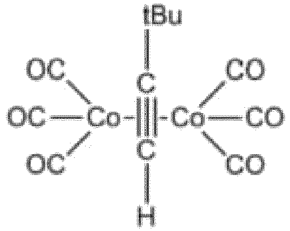
the method comprises a motion of the raw material liquid in the vaporizer by stirring the raw material liquid with a stirring member, thereby motioning the raw material liquid to increase a contact area between the raw material liquid and the gas phase,
a temperature of the raw material liquid in the vaporizer is 350°C or lower,
the gas phase part comprises a decomposition product of the raw material compound, and
the substrate is a copper substrate.

15. A film deposition apparatus comprising:
a vaporizer that vaporizes a raw material liquid comprising a raw material compound;
a discharging member that discharges a gas phase in the vaporizer; and
a film deposition chamber that deposits a film on a substrate by atomic layer deposition.

16. The film deposition apparatus according to claim 15, wherein the vaporizer comprises a motion member that moves the raw material liquid comprising the raw material compound.

17. The film deposition apparatus according to claim 15, wherein the motion member is a stirring member.

18. The film deposition apparatus according to claim 15, wherein a temperature of the raw material liquid in the vaporizer is 400°C or lower.

19. The film deposition apparatus according to claim 15, further comprising a connecting section that connects the vaporizer and the film deposition chamber, wherein a partial pressure of the raw material compound in the vaporizer is substantially the same as a partial pressure of the raw material compound in the vaporizer.
